# EUROPÄISCHE PATENTANMELDUNG

(11) **EP 3 955 288 A1**
(43) Veröffentlichungstag der Anmeldung: **16.02.2022**
(21) Anmeldenummer: 20190870.4
(22) Anmeldetag: 13.08.2020
(51) Int. Cl.: H01L 23/488, H01L 21/60, H01L 23/373, H01L 21/48

(54) **LEISTUNGSMODUL MIT EINER VERBINDUNGSSCHICHT AUFWEISEND EINE LOTSCHICHT UND EINEN ABSTANDSHALTER, ELEKTRISCHES GERÄT MIT DEM LEISTUNGSMODUL UND VERFAHREN ZUR HERSTELLUNG DES LEISTUNGSMODULS**

(71) Anmelder: Siemens Aktiengesellschaft, 80333 München (DE)
(72) Erfinder: Kneißl, Philipp, 90427 Nürnberg (DE); Kürten, Bernd, 90587 Obermichelbach (DE); Namyslo, Lutz, 91353 Hausen (DE)

(57) **Zusammenfassung**

Ein Leistungsmodul (1) umfasst eine elektrisch isolierende Schicht (2), eine erste elektrisch leitende Schicht (3), welche auf der elektrisch isolierenden Schicht (2) angeordnet ist (die Teile eines DCB- oder IMS-Substrats sein können), eine erste Lotschicht (4), welche auf der ersten elektrisch leitenden Schicht (3) angeordnet ist, und zumindest ein Leistungs-Bauelement (5), welches jeweils auf der ersten Lotschicht (4) angeordnet ist, wobei ein erster Abstandshalter (6) jeweils zwischen dem jeweiligen Leistungs-Bauelement (5) und der ersten elektrisch leitenden Schicht (3) bzw. der elektrisch isolierenden Schicht (2) angeordnet ist. Alternativ umfasst ein Leistungsmodul (1) eine Bodenplatte (15), eine zweite Lotschicht (14), welche auf der Bodenplatte (15) angeordnet ist, eine zweite elektrisch leitende Schicht (13), welche auf der zweiten Lotschicht (14) angeordnet ist, eine elektrisch isolierende Schicht (2), welche auf der zweiten elektrisch leitenden Schicht (13) angeordnet ist, eine erste elektrisch leitende Schicht (3), welche auf der elektrisch isolierenden Schicht (2) angeordnet ist (wobei die zwei elektrisch leitenden Schichten (3, 13) und die elektrisch isolierende Schicht (2) als ein DCB- oder IMS-Substrat ausgebildet sein können), eine erste Lotschicht (4), welche auf der ersten elektrisch leitenden Schicht (3) angeordnet ist, und zumindest ein Leistungs-Bauelement (5), welches jeweils auf der ersten Lotschicht (4) angeordnet ist, wobei zumindest ein zweiter Abstandshalter (16) jeweils zwischen der Bodenplatte (15) und der zweiten elektrisch leitenden Schicht (13) angeordnet ist. Das Leistungsmodul (1) kann auch sowohl den ersten als auch den zweiten Abstandshalter (6, 16) aufweisen. Der jeweilige Abstandshalter (6, 16) und die jeweilige elektrisch leitende Schicht (3, 13) können einstückig ausgebildet sein, insbesondere wobei die jeweilige elektrisch leitende Schicht (3, 13) in der Umgebung des jeweiligen Abstandshalters (6, 16) zumindest eine Vertiefung (8, 18) aufweist und wobei der jeweilige Abstandshalter (6, 16) als zumindest ein Vorsprung (9, 19) der jeweiligen elektrisch leitenden Schicht (3, 13) ausgestaltet ist, wobei je Abstandshalter (6, 16) die zumindest eine Vertiefung (8, 18) im Wesentlichen dasselbe Volumen wie der zumindest eine Vorsprung (9, 19) aufweisen kann, oder insbesondere wobei der jeweilige Abstandshalter (6, 16) durch teilweises Abtragen der jeweiligen elektrisch leitenden Schicht (3, 13) ausgebildet ist, insbesondere mittels Ätzen oder Fräsen. Alternativ kann der jeweilige Abstandshalter (6, 16) additiv auf der jeweiligen elektrisch leitenden Schicht (3, 13) ausgebildet sein, wobei der jeweilige Abstandshalter (6, 16) lötfähiges Material, lötfähig beschichtetes Material, Bonddraht, Kupfer, Kupferpaste und/oder Silber aufweist und/oder wobei der jeweilige Abstandshalter (6, 16) mittels 3D-Druck, mittels eines Beschichtungsverfahrens, insbesondere Kaltgasspritzen, oder mittels Siebdruckes ausgebildet ist. Ein elektrisches Gerät (10), insbesondere Umrichter, kann zumindest ein derartiges Leistungsmodul (1) aufweisen. Dank dem jeweiligen Abstandshalter (6, 16) kann die Dicke der jeweiligen Lotschicht (4, 14) optimiert werden, so dass sie eine gute elektrische und thermische Leitfähigkeit aufweist und Verspannungen auf Grund von thermischen Ausdehnungen kompensieren kann und so dass sich keine Risse bilden und die jeweilige Lotschicht (4, 14) nicht brüchig wird.

## Beschreibung

Die Erfindung betrifft gemäß einem ersten Aspekt ein Leistungsmodul umfassend eine elektrisch isolierende Schicht, eine erste elektrisch leitende Schicht, welche auf der elektrisch isolierenden Schicht angeordnet ist, eine erste Lotschicht, welche auf der erste elektrisch leitenden Schicht angeordnet ist und zumindest ein Leistungs-Bauelement, welches jeweils auf der ersten Lotschicht angeordnet ist.

Weiterhin betrifft die Erfindung gemäß einem zweiten Aspekt ein Leistungsmodul umfassend eine Bodenplatte aufweisend eine plane Oberfläche, eine zweite Lotschicht, welche auf der Bodenplatte angeordnet ist, eine zweite elektrisch leitende Schicht, welche auf der zweiten Lotschicht angeordnet ist, eine elektrisch isolierende Schicht, welche auf der zweiten elektrisch leitenden Schicht angeordnet ist, eine erste elektrisch leitende Schicht, welche auf der elektrisch isolierenden Schicht angeordnet ist, eine erste Lotschicht, welche auf der ersten elektrisch leitenden Schicht angeordnet ist und zumindest ein Leistungs-Bauelement, welches jeweils auf der ersten Lotschicht angeordnet ist.

Weiterhin betrifft die Erfindung ein jeweiliges elektrisches Gerät aufweisend zumindest ein jeweiliges, derartiges Leistungsmodul.

Schließlich betrifft die Erfindung je ein Verfahren zur Herstellung eines jeweiligen, derartigen Leistungsmoduls.

Derartige Vorrichtungen bzw. ein derartiges Verfahren kommen in einer Vielzahl von Anwendungen in der Leistungselektronik zum Einsatz.

Bei thermisch beanspruchten Bauteilen hängt die Zuverlässigkeit oftmals von der Stärke der Lotschicht ab. Eine zu dicke Lotschicht verschlechtert die Wärmeabfuhr, eine zu dünne Schicht kann Verspannungen auf Grund von thermischen Ausdehnungen nicht kompensieren. Bei Lötungen von flächigen Bauteilen kann es zu einer Verkippung kommen, so dass im Extremfall eine Kante vom Bauteil auf dem Schaltungsträger aufliegt, also eine sehr dünne Lotschicht auf dieser Seite hat, dafür aber auf der anderen Seite eine doppelt so dicke Lotschicht mit schlechter Entwärmung hat.

Außerdem führt eine Verkippung zu Problemen bei nachfolgenden Prozessen, wie z.B. beim Drahtbonden.

Um diese Nachteile zu verringern oder zu vermeiden, können verschiedene Methoden angewandt werden. Einerseits solche, bei denen versucht wird, den Chip beim Lötvorgang parallel zum Schaltungsträger auszurichten, z.B. mit Hilfe von Gewichten. Dies ist einerseits prozesstechnisch aufwendig und kann das Problem auf Grund hoher Toleranzen nur reduzieren. Andererseits gibt es Lotmaterialien, die Abstandshalter enthalten, z. B. in Form von kleinen Kugeln. Diese verschlechtern allerdings die Eigenschaften der Lotschicht hinsichtlich der Strom- und Wärmeleitfähigkeit und/oder hinsichtlich der Fähigkeit, Verspannungen zu kompensieren.

Ähnliche Schwierigkeiten treten bei der Verbindung der zweiten elektrisch leitenden Schicht, mit der Bodenplatte auf und können bislang nur unzureichend behoben werden.

Eine Aufgabe der Erfindung ist es, ein verbessertes Leistungsmodul, ein entsprechendes elektrisches Gerät und ein entsprechendes Verfahren bereitzustellen, welche insbesondere die genannten Nachteile überwinden.

Eine Lösung der Aufgabe ergibt sich gemäß einem ersten Aspekt der Erfindung durch ein Leistungsmodul der eingangs genannten Art dadurch, dass das Leistungsmodul zumindest einen ersten Abstandshalter aufweist, der jeweils zwischen dem jeweiligen Leistungs-Bauelement und der erste elektrisch leitenden Schicht bzw. der elektrisch isolierenden Schicht angeordnet ist.

Eine weitere Lösung der Aufgabe ergibt gemäß sich einem zweiten Aspekt der Erfindung durch ein Leistungsmodul der eingangs genannten Art dadurch, dass das Leistungsmodul zumindest einen zweiten Abstandshalter aufweist, der jeweils zwischen der Bodenplatte und der zweiten elektrisch leitenden Schicht angeordnet ist.

Eine zusätzliche Lösung der Aufgabe ergibt gemäß einem dritten Aspekt der Erfindung durch eine Kombination der Merkmale der beiden vorgeschlagenen Leistungsmodule zu einem Leistungsmodul umfassend eine Bodenplatte, eine zweite Lotschicht, welche auf der Bodenplatte angeordnet ist, eine zweite elektrisch leitende Schicht, welche auf der zweiten Lotschicht angeordnet ist, eine elektrisch isolierende Schicht, welche auf der zweiten elektrisch leitenden Schicht angeordnet ist, eine erste elektrisch leitende Schicht, welche auf der elektrisch isolierenden Schicht angeordnet ist, eine erste Lotschicht, welche auf der ersten elektrisch leitenden Schicht angeordnet ist und zumindest ein Leistungs-Bauelement, welches jeweils auf der ersten Lotschicht angeordnet ist dadurch gekennzeichnet, dass das Leistungsmodul zumindest einen ersten Abstandshalter, der jeweils zwischen dem jeweiligen Leistungs-Bauelement und der ersten elektrisch leitenden Schicht bzw. der elektrisch isolierenden Schicht angeordnet ist, und zumindest einen zweiten Abstandshalter aufweist, der jeweils zwischen der Bodenplatte und der zweiten elektrisch leitenden Schicht angeordnet ist.

Weiterhin ergibt sich eine Lösung der Aufgabe durch ein elektrisches Gerät der eingangs genannten Art dadurch, dass das elektrische Gerät zumindest eines des vorgeschlagenen Leistungsmoduls aufweist.

Ferner ergibt sich eine Lösung der Aufgabe durch ein Verfahren zur Herstellung des vorgeschlagenen Leistungsmoduls gemäß dem ersten Aspekt durch folgende Verfahrensschritte:
- Bereitstellen einer elektrisch isolierenden Schicht, einer ersten elektrisch leitenden Schicht, welche auf der elektrisch isolierenden Schicht angeordnet ist, sowie zumindest eines Leistungs-Bauelementes,
- Ausformen zumindest eines ersten Abstandshalters, der jeweils zwischen einem Bereich, an welchem das jeweilige Leistungs-Bauelement anzuordnen ist, und der ersten elektrisch leitenden Schicht bzw. der elektrisch isolierenden Schicht angeordnet ist,
- Anbringen einer ersten Lotschicht auf der ersten elektrisch leitenden Schicht zwischen der ersten elektrisch leitenden Schicht und dem Bereich, an welchem das jeweilige Leistungs-Bauelement anzuordnen ist,
- Anbringen des jeweiligen Leistungs-Bauelementes auf der ersten Lotschicht und dem jeweiligen ersten Abstandshalter an dem Bereich, an welchem das jeweilige Leistungs-Bauelement anzuordnen ist.

Vorzugsweise wird bei diesem Herstellungsverfahren zunächst der jeweilige erste Abstandshalter ausgeformt, bevor die erste Lotschicht angebracht wird.

Außerdem ergibt sich eine Lösung der Aufgabe durch ein Verfahren zur Herstellung des vorgeschlagenen Leistungsmoduls gemäß dem zweiten Aspekt durch folgende Verfahrensschritte:
- Bereitstellen einer Bodenplatte, einer zweiten elektrisch leitende Schicht, einer elektrisch isolierende Schicht, welche auf der zweiten elektrisch leitenden Schicht angeordnet ist, einer erste elektrisch leitende Schicht, welche auf der elektrisch isolierenden Schicht angeordnet ist, einer ersten Lotschicht, welche auf der ersten elektrisch leitenden Schicht angeordnet ist und zumindest eines Leistungs-Bauelement, welches jeweils auf der ersten Lotschicht angeordnet ist,
- Ausformen zumindest eines zweiten Abstandshalters, der jeweils zwischen der Bodenplatte und der zweiten elektrisch leitenden Schicht angeordnet ist,
- Anbringen einer zweiten Lotschicht auf der zweiten elektrisch leitenden Schicht zwischen der zweiten elektrisch leitenden Schicht und dem Bereich, an welchem die Bodenplatte anzuordnen ist,
- Anbringen der Bodenplatte auf der zweiten Lotschicht und dem jeweiligen zweiten Abstandshalter an dem Bereich, an welchem die Bodenplatte anzuordnen ist.

Vorzugsweise wird bei diesem Herstellungsverfahren zunächst der jeweilige zweite Abstandshalter ausgeformt, bevor die zweite Lotschicht angebracht wird.

Schließlich ergibt sich eine Lösung der Aufgabe durch ein Verfahren zur Herstellung des kombinierten Leistungsmoduls durch folgende Verfahrensschritte:
- Bereitstellen einer Bodenplatte, einer zweiten elektrisch leitende Schicht, einer elektrisch isolierende Schicht, welche auf der zweiten elektrisch leitenden Schicht angeordnet ist, einer erste elektrisch leitende Schicht, welche auf der elektrisch isolierenden Schicht angeordnet ist, einer ersten Lotschicht, welche auf der ersten elektrisch leitenden Schicht angeordnet ist und zumindest eines Leistungs-Bauelement, welches jeweils auf der ersten Lotschicht angeordnet ist,
- Ausformen zumindest eines ersten Abstandshalters, der jeweils zwischen einem Bereich, an welchem das jeweilige Leistungs-Bauelement anzuordnen ist, und der ersten elektrisch leitenden Schicht bzw. der elektrisch isolierenden Schicht angeordnet ist,
- Anbringen einer ersten Lotschicht auf der ersten elektrisch leitenden Schicht zwischen der ersten elektrisch leitenden Schicht und dem Bereich, an welchem das jeweilige Leistungs-Bauelement anzuordnen ist,
- Anbringen des jeweiligen Leistungs-Bauelementes auf der ersten Lotschicht und dem jeweiligen ersten Abstandshalter an dem Bereich, an welchem das jeweilige Leistungs-Bauelement anzuordnen ist,
- Ausformen zumindest eines zweiten Abstandshalters, der jeweils zwischen der Bodenplatte und der zweiten elektrisch leitenden Schicht angeordnet ist,
- Anbringen einer zweiten Lotschicht auf der zweiten elektrisch leitenden Schicht zwischen der zweiten elektrisch leitenden Schicht und dem Bereich, an welchem die Bodenplatte anzuordnen ist,
- Anbringen der Bodenplatte auf der zweiten Lotschicht und dem jeweiligen zweiten Abstandshalter an dem Bereich, an welchem die Bodenplatte anzuordnen ist.

Vorzugsweise wird bei diesem Herstellungsverfahren zunächst der jeweilige erste Abstandshalter ausgeformt, bevor die erste Lotschicht angebracht wird. Weiterhin wird bei diesem Herstellungsverfahren vorzugsweise zunächst der jeweilige zweite Abstandshalter ausgeformt, bevor die zweite Lotschicht angebracht wird. Dabei kann zunächst der zumindest eine erste Abstandshalter oder der zumindest eine zweite Abstandshalter ausgeformt werden. Gleiches gilt für das Anbringen der ersten Lotschicht und der zweiten Lotschicht sowie für das Anbringen des jeweiligen Leistungs-Bauelementes und der Bodenplatte. Insbesondere kann der jeweilige zweite Abstandshalter bereits bei der Herstellung der zweiten elektrisch leitenden Schicht ausgeformt werden. Denkbar sind weiterhin folgende Reihenfolgen der Verfahrensschritte: 1) zunächst das Leistungs-Bauelement auf der ersten elektrisch leitenden Schicht anbringen, bspw. anlöten, und anschließend die zweite elektrisch leitende Schicht auf der Bodenplatte anbringen (bzw. die Bodenplatte an der zweiten elektrisch leitenden Schicht), bspw. anlöten; 2) umgekehrt, d.h. die zweite elektrisch leitende Schicht auf der Bodenplatte anbringen (bzw. die Bodenplatte an der zweiten elektrisch leitenden Schicht), bspw. anlöten, und anschließend das Leistungs-Bauelement auf der ersten elektrisch leitenden Schicht anbringen, bspw. anlöten; und 3) paralleles Anbringen, bspw. Anlöten, des Leistungs-Bauelementes auf der ersten elektrisch leitenden Schicht und der zweiten elektrisch leitenden Schicht auf der Bodenplatte (bzw. der Bodenplatte an der zweiten elektrisch leitenden Schicht).

Das vorgeschlagene Leistungsmodul weist somit eine elektrisch isolierende Schicht auf, welche bspw. eine isolierende Keramik umfassen kann. Die elektrische isolierende Schicht kann insbesondere quaderförmig ausgestaltet sein und dabei eine im Vergleich zu seiner rechteckigen Grundfläche recht dünne Schichthöhe aufweisen.

Auf der elektrisch isolierenden Schicht ist die erste elektrisch leitende Schicht angeordnet, welche bspw. als Kupfer-Schicht ausgestaltet ist. Die erste elektrisch leitende Schicht kann dabei eine Oberfläche, insbesondere eine der beiden rechteckigen Grundflächen, der elektrisch isolierenden Schicht vollständig oder teilweise bedecken.

Insbesondere können die elektrische isolierende Schicht und die erste elektrisch leitende Schicht durch ein DCB-Substrat (direct bonded copper) oder ein IMS (insulated metal substrate) sein. verwirklicht werden. Dabei handelt es sich insbesondere um keramische Trägerstrukturen, auf die elektrische Leiterbahnen und ggf. ein oder mehrere Halbleiterchips, Leistungs-Bauelemente oder andere Bauelemente aufgebracht sind bzw. werden.

Auf der ersten elektrisch leitenden Schicht ist die erste Lotschicht angeordnet, insbesondere auf jener Oberfläche der ersten elektrisch leitenden Schicht, welche der elektrisch isolierenden Schicht abgewandt ist. Die erste Lotschicht weist Lot auf, d. h. ein Mittel, das Metalle durch Löten verbindet. Das Lot besteht bspw. aus einer Mischung bzw. Legierung unterschiedlicher Metalle. Besonders häufig werden hierfür Blei, Zinn, Zink, Silber und Kupfer verwendet. Die erste Lotschicht kann dabei die genannte Oberfläche der ersten elektrisch leitenden Schicht vollständig, vorzugsweise jedoch lediglich teilweise bedecken.

Auf der ersten Lotschicht ist zumindest ein Leistungs-Bauelement angeordnet. Als Leistungs-Bauelement kann bspw. einen Halbleiter-Bauelement bzw. Leistungs-Halbleiter eingesetzt werden, d. h. insb. auf Halbleitern, wie z. B. Silizium, Galliumnitrid oder Siliziumcarbid, basierende Bauelemente, die in der Leistungselektronik für das Steuern und Schalten hoher elektrischer Ströme und Spannungen ausgelegt sind, d. h. insbesondere Ströme von mehr als 1 Ampere und Spannungen von mehr als etwa 24 Volt. Beispiele solcher Bauelemente sind Leistungsdioden, Thyristoren, Triacs und Transistoren, wie zum Beispiel Leistungs-MOSFETs, IGBTs und dergleichen. Weiterhin kann als Leistungs-Bauelement ein elektrischer Widerstand, bspw. ein Messwiderstand, eingesetzt werden.

Oftmals sind derartige Leistungs-Bauelemente vergleichsweise dünne Bauelemente, d. h. die Abmessungen der Grundfläche sind wesentlich größer als die Dicke des jeweiligen Bauelementes senkrecht zur Grundfläche. Insbesondere haben derartige Leistungs-Bauelemente eine im Wesentlichen flache Unterseite, bspw. da sie im Wesentlichen quaderförmig oder zylinderförmig sind. Insbesondere liegt die Unterseite des Leistungs-Bauelementes auf der ersten Lotschicht auf.

Weiterhin weist das vorgeschlagene Leistungsmodul gemäß dem ersten Aspekt zumindest einen ersten Abstandshalter auf, der jeweils zwischen dem Leistungs-Bauelement und der ersten elektrisch leitenden Schicht bzw. der elektrisch isolierenden Schicht angeordnet ist. Vorzugsweise ist der jeweilige erste Abstandshalter derart ausgestaltet bzw. angeordnet, dass das jeweilige Leistungs-Bauelement auf einer Seite des jeweiligen ersten Abstandshalters aufliegt bzw. diesen berührt. Auf der anderen Seite des jeweiligen ersten Abstandshalters ist entweder die erste elektrisch leitende Schicht oder die elektrische isolierende Schicht angeordnet, wodurch im Bereich des jeweiligen ersten Abstandshalters ein definierter Abstand zwischen dem jeweiligen Leistungs-Bauelement und der ersten elektrisch leitenden Schicht bzw. der elektrisch isolierenden Schicht gewährleistet werden kann.

Zumindest zwei Varianten sind dabei denkbar: Gemäß einer ersten Variante kann der jeweilige erste Abstandshalter als zur ersten elektrisch leitenden Schicht separates Bauteil ausgestaltet sein, sodass der jeweilige erste Abstandshalter zwischen dem Leistungs-Bauelement und der ersten elektrisch leitenden Schicht angeordnet ist. Gemäß einer zweiten Variante kann der jeweilige erste Abstandshalter einstückig mit der ersten elektrisch leitenden Schicht ausgestaltet sein, wobei sich der jeweilige erste Abstandshalter in Richtung zum jeweiligen Leistungs-Bauelement aus der ersten elektrisch leitenden Schicht mit einer bestimmten Schichtdicke erhebt. In dieser zweiten Variante ist der jeweilige erste Abstandshalter zwischen dem Leistungs-Bauelement und der ersten elektrisch leitenden Schicht angeordnet. Da sich der jeweilige erste Abstandshalter, wie kurz erwähnt, aus der ersten elektrisch leitenden Schicht mit der bestimmten Schichtdicke erhebt, könnte man auch davon sprechen, dass auch gemäß dieser zweiten Variante der jeweilige erste Abstandshalter zwischen dem Leistungs-Bauelement und der ersten elektrisch leitenden Schicht mit der bestimmten Schichtdicke angeordnet ist.

Dank dem vorgeschlagenen Leistungsmodul gemäß dem zweiten Aspekt können mehrere Vorteile erzielt werden. So kann bspw. eine gleichmäßige Schichtdicke der Bauteile sichergestellt werden. Dies kann insbesondere dadurch erreicht werden, dass durch den jeweiligen ersten Abstandshalter ein Verkippen des Leistungs-Bauelementes während des Fertigungsprozesses zuverlässig verhindert werden kann. Somit kann eine erste Lotschicht mit einer im Wesentlichen definierten Schichtdicke erzielt werden bzw. eine erste Lotschicht, welche zumindest stets eine Dicke innerhalb eines Intervalls mit einer Mindestdicke und einer Maximaldicke aufweist. Insgesamt weist somit auch das vorgeschlagene Leistungsmodul eine im Wesentlichen definierten Moduldicke im Bereich des jeweiligen Leistungs-Bauelementes auf. In anderen Worten kann dank des jeweiligen ersten Abstandshalters auf dem Schaltungsträger eine wesentlich präzisere Schichtdicke der ersten Lotschicht erzielt werden, was in einer längeren Lebensdauer des Leistungsmoduls resultiert. Dies wiederum hat geringere Halbleiterkosten zur Folge sowie eine Reduzierung des Produktionsaufwandes im Reinraum. Dies wird bspw. dadurch erzielt, dass keine Be- und Entstückung von Gewichten zur Ausrichtung des jeweiligen Leistungs-Bauelementes während der Herstellung erforderlich ist.

Weiterhin weist das vorgeschlagene Leistungsmodul gemäß dem zweiten Aspekt eine zweite elektrisch leitende Schicht auf, auf welcher die elektrische isolierende Schicht angeordnet ist. Dabei können die drei Schichten der zweiten elektrisch leitenden Schicht, der elektrisch isolierenden Schicht und der ersten elektrisch leitenden Schicht als das oben erläuterte DCB-Substrat oder IMS ausgebildet sein, wobei bei der Ausgestaltung als DCB-Substrat die beiden elektrisch leitenden Schicht dann bspw. als Kupfer gefertigt sein können bzw. dieses mehrheitlich umfassen. Das vorgeschlagene Leistungsmodul weist weiterhin eine Bodenplatte auf, auf welcher eine zweite Lotschicht angeordnet ist. Auf der zweiten Lotschicht ist wiederum die bereits erwähnte zweite elektrisch leitende Schicht angeordnet.

Das vorgeschlagene Leistungsmodul gemäß dem zweiten Aspekt weist weiterhin zumindest einen zweiten Abstandshalter auf, der jeweils zwischen der Bodenplatte und der zweiten elektrisch leitenden Schicht angeordnet ist. Die Bodenplatte kann dabei metallisch sein und zum Beispiel aus Stahl oder Kupfer gefertigt sein. Insbesondere weist die Bodenplatte eine im Wesentlichen plane Oberfläche auf, auf welcher die zweite Lotschicht und der jeweilige zweite Abstandshalter angeordnet sind. Bspw. kann die Oberfläche der Bodenplatte dabei zumindest im Bereich des jeweiligen zweiten Abstandshalters im Wesentlichen plan ausgeführt sein, d.h. insb. dass Höhenunterschiede der Oberfläche der Bodenplatte gegenüber der Höhe des jeweiligen zweiten Abstandshalters klein sind, insb. eine oder zwei Größenordnungen kleiner. Die Oberfläche der Bodenplatte kann in diesem Kontext immer noch als plan angesehen werden, wenn sie ansonsten eine leichte Wölbung, bspw. zwischen ca. 50 µm und 1.000 µm aufweist.

Vorzugsweise ist der jeweilige zweite Abstandshalter derart ausgestaltet bzw. angeordnet, dass die Bodenplatte auf einer Seite des jeweiligen zweiten Abstandshalters aufliegt bzw. diesen berührt. Auf der anderen Seite des jeweiligen zweiten Abstandshalters ist die zweite elektrisch leitende Schicht angeordnet, wodurch im Bereich des jeweiligen zweiten Abstandshalters ein definierter Abstand zwischen der Bodenplatte und der zweiten elektrisch leitenden Schicht gewährleistet werden kann.

Zumindest zwei Varianten sind dabei wiederum denkbar: Gemäß einer ersten Variante kann der jeweilige zweite Abstandshalter als zur zweiten elektrisch leitenden Schicht separates Bauteil ausgestaltet sein, sodass der jeweilige zweite Abstandshalter zwischen der Bodenplatte und der zweiten elektrisch leitenden Schicht angeordnet ist. Gemäß einer zweiten Variante kann der jeweilige zweite Abstandshalter einstückig mit der zweiten elektrisch leitenden Schicht ausgestaltet sein, wobei sich der jeweilige zweite Abstandshalter in Richtung zur Bodenplatte aus der zweiten elektrisch leitenden Schicht mit einer bestimmten Schichtdicke erhebt.

Dank dem vorgeschlagenen Leistungsmodul gemäß dem zweiten Aspekt können mehrere Vorteile erzielt werden. So kann bspw. wiederum eine gleichmäßige Schichtdicke der Bauteile sichergestellt werden. Dies kann insbesondere dadurch erreicht werden, dass durch den jeweiligen zweiten Abstandshalter ein Verkippen der Bodenplatte während des Fertigungsprozesses zuverlässig verhindert werden kann. Somit kann eine zweite Lotschicht mit einer im Wesentlichen einheitlichen Schichtdicke erzielt werden bzw. eine zweite Lotschicht, welche zumindest stets eine Dicke innerhalb eines Intervalls mit einer Mindestdicke und einer Maximaldicke aufweist. Insgesamt weist somit auch das vorgeschlagene Leistungsmodul eine im Wesentlichen einheitlichen Moduldicke im Bereich der Bodenplatte auf. In anderen Worten kann dank des jeweiligen zweiten Abstandshalters auf dem Schaltungsträger eine wesentlich präzisere Schichtdicke der zweiten Lotschicht erzielt werden, was in einer längeren Lebensdauer des Leistungsmoduls resultiert. Dies wiederum hat eine Reduzierung des Produktionsaufwandes im Reinraum zur Folge. Dies wird bspw. dadurch erzielt, dass keine Be- und Entstückung von Gewichten zur Ausrichtung der Bodenplatte während der Herstellung erforderlich ist.

Wie bereits erwähnt, kann auch ein Leistungsmodul ausgebildet werden, welches die beiden Aspekte kombiniert und somit sowohl einen jeweiligen ersten Abstandshalter und einen jeweiligen zweiten Abstandshalter aufweist.

Vorzugsweise findet das vorgeschlagene Leistungsmodul Anwendung in einem Gleichrichter, Wechselrichter bzw. ganz allgemein Umrichter oder Stromrichter. Insbesondere kann das vorgeschlagene Leistungsmodul oder ein entsprechender Umrichter bei elektrisch oder hybrid-angetriebenen Fahrzeugen, wie zum Beispiel bei Zügen, Autos oder Flugzeugen eingesetzt werden. Das vorgeschlagene elektrische Gerät, welches das vorgeschlagene Leistungsmodul aufweist, kann entsprechend als Gleichrichter, Wechselrichter bzw. ganz allgemein Umrichter oder Stromrichter ausgestaltet sein und in die genannten Fahrzeuge eingebaut werden.

Bei einer vorteilhaften Ausgestaltung der Erfindung liegt das jeweilige Leistungs-Bauelement und/oder die Bodenplatte auf dem jeweiligen Abstandshalter auf. Gemäß dem ersten Aspekt ist das Leistungsmodul also derart ausgestaltet, dass das jeweilige Leistungs-Bauelement auf dem jeweiligen ersten Abstandshalters aufliegt, und gemäß dem zweiten Aspekt ist das Leistungsmodul wohl derart ausgestaltet, dass die Bodenplatte auf dem jeweiligen zweiten Abstandshalter aufliegt. Wie bereits erwähnt, kann auch ein Leistungsmodul ausgebildet werden, welches die beiden Aspekte kombiniert und somit sowohl einen jeweiligen ersten Abstandshalter und einen jeweiligen zweiten Abstandshalter aufweist. Derartige Ausgestaltungen sind auch bei den weiteren, vorteilhaften Ausgestaltungen der Erfindung realisierbar.

Durch das Aufliegen des jeweiligen ersten Abstandshalters auf dem jeweiligen Leistungs-Bauelement lässt sich das jeweilige Leistungs-Bauelement präzise in Bezug auf die erste elektrisch leitende Schicht bzw. elektrisch isolierende Schicht positionieren, wodurch unter anderem eine erste Lotschicht mit einer gleichmäßigen und präzisen Schichtdicke ermöglicht wird. Entsprechend lässt sich durch das Aufliegen des jeweiligen zweiten Abstandshalters auf der Bodenplatte die Bodenplatte präzise in Bezug auf die zweite elektrisch leitende Schicht positionieren, wodurch unter anderem eine zweite Lotschicht mit einer gleichmäßigen und präzisen Schichtdicke ermöglicht wird.

Bei einer weiteren vorteilhaften Ausgestaltung der Erfindung ist der jeweilige Abstandshalter zumindest teilweise in dem Raum einerseits zwischen dem jeweiligen Leistungs-Bauelement bzw. der Bodenplatte und andererseits der erste elektrisch leitenden Schicht bzw. der elektrisch isolierenden Schicht bzw. der zweiten elektrisch leitenden Schicht angeordnet.

Das jeweilige Leistungs-Bauelement ist innerhalb des Leistungsmoduls an einer bestimmten Position relativ zur ersten elektrisch leitenden Schicht bzw. zur elektrisch isolierenden Schicht vorgesehen. Dabei ist zwischen dem jeweiligen Leistungs-Bauelement und der ersten elektrisch leitenden Schicht bzw. der elektrischen isolierenden Schicht ein bestimmter Raum angeordnet, in welchem der jeweilige erste Abstandshalter zumindest teilweise angeordnet ist. Das bedeutet insbesondere, dass der jeweilige erste Abstandshalter teilweise außerhalb des genannten Raums angeordnet sein kann, aber zumindest auch teilweise innerhalb des genannten Raums angeordnet ist. Bspw. kann der jeweilige erste Abstandshalter auch vollständig in dem genannten Raum angeordnet sein.

Der genannte Raum kann dabei prinzipiell durch Verbindungslinien zwischen dem jeweiligen Leistungs-Bauelement und der erste elektrisch leitenden Schicht bzw. der elektrischen isolierenden Schicht eingefasst werden, wodurch bspw. ein dreidimensionaler Körper entsteht, der zwei zueinander parallele Flächen aufweist, nämlich die Unterseite des jeweiligen Leistungs-Bauelementes und die dem jeweiligen Leistungs-Bauelement zugewandte Oberseite der erste elektrisch leitenden Schicht bzw. der elektrischen isolierenden Schicht.

Insbesondere kann der genannte Raum auch der Gestalt sein, dass er durch eine Projektion des jeweiligen Leistungs-Bauelementes auf die erste elektrisch leitende Schicht bzw. die elektrisch isolierende Schicht eingefasst ist, wobei die Projektion senkrecht auf die erste elektrisch leitende Schicht bzw. die elektrische isolierende Schicht erfolgt. Ein derartiger Raum hätte die Form eines Quaders, Prismas oder Zylinders, je nach räumlicher Ausgestaltung des jeweiligen Leistungs-Bauelementes. Auch bei einem derartigen Raum ist der jeweilige erste Abstandshalter zumindest teilweise, vorzugsweise vollständig, in diesem quader-, prismen- bzw. zylinderförmigen Raum angeordnet.

Vorzugsweise ist in dem übrigen Raum des bspw. quader-, prismen- bzw. zylinderförmigen Raums, in welchem also keinen jeweilige ersten Abstandshalter angeordnet ist, das Lot der ersten Lotschicht angeordnet.

Die Bodenplatte ist innerhalb des Leistungsmoduls an einer bestimmten Position relativ zur zweiten elektrisch leitenden Schicht vorgesehen. Dabei ist zwischen der Bodenplatte und der zweiten elektrisch leitenden Schicht ebenfalls ein bestimmter Raum angeordnet, in welchem der jeweilige zweite Abstandshalter zumindest teilweise angeordnet ist. Das bedeutet insbesondere, dass der jeweilige zweite Abstandshalter teilweise außerhalb des genannten Raums angeordnet sein kann, aber zumindest auch teilweise innerhalb des genannten Raums angeordnet ist. Bspw. kann der jeweilige zweite Abstandshalter auch vollständig in dem genannten Raum angeordnet sein.

Der genannte Raum kann dabei prinzipiell durch Verbindungslinien zwischen der Bodenplatte und der zweiten elektrisch leitenden Schicht eingefasst werden, wodurch bspw. ein dreidimensionaler Körper entsteht, der zwei zueinander parallele Flächen aufweist, nämlich die Bodenplatte und die der Bodenplatte zugewandte Unterseite der zweiten elektrisch leitenden Schicht.

Insbesondere kann der genannte Raum auch der Gestalt sein, dass er durch eine Projektion der Bodenplatte auf die zweite elektrisch leitende Schicht eingefasst ist, wobei die Projektion senkrecht auf die zweite elektrisch leitende Schicht erfolgt. Ein derartiger Raum hätte wiederum die Form eines Quaders, Prismas oder Zylinders, je nach räumlicher Ausgestaltung der Bodenplatte. Auch bei einem derartigen Raum ist der jeweilige zweite Abstandshalter zumindest teilweise, vorzugsweise vollständig, in diesem quader-, prismen- bzw. zylinderförmigen Raum angeordnet.

Vorzugsweise ist in dem übrigen Raum des bspw. quader-, prismen- bzw. zylinderförmigen Raums, in welchem also keinen jeweilige ersten Abstandshalter angeordnet ist, das Lot der zweiten Lotschicht angeordnet.

Bei einer weiteren vorteilhaften Ausgestaltung der Erfindung weisen der jeweilige Abstandshalter und die jeweilige Lotschicht jeweils eine Höhe bzw. Dicke von 10 µm bis 300 µm, vorzugsweise von 50 µm bis 150 µm, auf.

Dabei wird gemäß dem ersten Aspekt insb. angenommen, dass das jeweilige Leistungs-Bauelement eine im Wesentlichen plane bzw. flache Unterseite aufweist und dass die erste elektrisch leitende Schicht eine im Wesentlichen plane bzw. flache Oberseite aufweist, wobei die Unterseite des jeweiligen Leistungs-Bauelementes und die Oberseite der ersten elektrisch leitenden Schicht einander zugewandt sind. Selbst wenn die erste elektrisch leitende Schicht bzw. die zweite elektrisch leitende Schicht, insb. in der Umgebung des jeweiligen Abstandshalters, nicht völlig plan ausgestaltet ist, kann im vorliegenden Kontext angenommen werden, dass die jeweilige elektrisch leitende Schicht im Wesentlichen plan ist. Im vorliegenden Kontext wird insbesondere angenommen, dass die jeweilige elektrisch leitende Schicht im Wesentlichen plan ist, wenn zumindest 2/3, insbesondere zumindest 80%, zumindest 90% oder zumindest 95%, der genannten Ober- bzw. Unterseite der jeweiligen elektrisch leitenden Schicht dort plan ausgestaltet sind, wo gemäß dem ersten Aspekt die erste Lotschicht zwischen dem jeweiligen Leistungs-Bauelement und der erste elektrisch leitenden Schicht angeordnet ist bzw. wo gemäß dem zweiten Aspekt die zweite Lotschicht zwischen der Bodenplatte und der zweiten elektrisch leitenden Schicht angeordnet ist. Insbesondere können dabei zumindest 2/3, insbesondere zumindest 80%, zumindest 90% oder zumindest 95%, der genannten Ober- bzw. Unterseite der ersten bzw. zweiten elektrisch leitenden Schicht plan ausgestaltet sein, die den oben erläuterten, insbesondere bspw. quader-, prismen- bzw. zylinderförmigen Raum gemäß dem ersten Aspekt zwischen dem jeweiligen Leistungs-Bauelement und der erste elektrisch leitenden Schicht bzw. der elektrischen isolierenden Schicht eingrenzen bzw. gemäß dem zweiten Aspekt zwischen der Bodenplatte und der zweiten elektrisch leitenden Schicht.

Weist die jeweilige elektrisch leitende Schicht im Bereich des jeweiligen Abstandshalters somit Vertiefungen bzw. Erhebungen gegenüber der sonst planen Oberfläche der jeweiligen elektrisch leitenden Schicht auf, so bezieht sich die Höhe des jeweiligen Abstandshalters auf die ansonsten plane Oberfläche der jeweiligen elektrisch leitenden Schicht. Die erste bzw. zweite Lotschicht ist dann derart ausgestaltet, dass ihre Dicke im Bereich gemäß dem ersten Aspekt zwischen dem jeweiligen Leistungs-Bauelement und der ersten elektrisch leitenden Schicht bzw. gemäß dem zweiten Aspekt zwischen der Bodenplatte und der zweiten elektrisch leitenden Schicht, insbesondere in dem oben erläuterten bspw. quader-, prismen- bzw. zylinderförmigen Raum, eine Dicke von 10 µm bis 300 µm, vorzugsweise von 50 µm bis 150 µm, aufweist.

Besonders gute Ergebnisse lassen sich erzielen, wenn der jeweilige Abstandshalter und somit auch die erste bzw. zweite Lotschicht eine Höhe bzw. Dicke im Bereich von 90 µm bis 110 µm, d. h. etwa 100 µm, aufweisen. Dies liegt daran, dass einerseits die jeweilige Lotschicht bei einer Dicke von weniger als 100 um schneller altert, Risse bildet und somit brüchig wird und andererseits die jeweilige Lotschicht bei größeren Dicken eine schlechtere elektrische und thermische Leitfähigkeit aufweist.

Vorzugsweise weist die jeweilige Lotschicht dabei eine zumindest im Randbereich gleichmäßige Dicke auf, die bspw. in dem oben erläuterten bspw. quader-, prismen- bzw. zylinderförmigen Raum eine Toleranz bezüglich ihrer Dicke von ±20%, insb. ±10% aufweist.

Bei einer weiteren vorteilhaften Ausgestaltung der Erfindung sind gemäß dem ersten Aspekt der jeweilige erste Abstandshalter und die erste elektrisch leitende Schicht einstückig ausgebildet bzw. gemäß dem zweiten Aspekt der jeweilige zweite Abstandshalter und die zweite elektrisch leitende Schicht einstückig ausgebildet. Insbesondere sind der jeweilige Abstandshalter und die jeweilige elektrisch leitende Schicht somit stoffschlüssig miteinander verbunden und bspw. aus demselben Material gefertigt. Bspw. bestehen somit sowohl die jeweilige elektrisch leitende Schicht als auch der jeweilige Abstandshalter im Wesentlichen aus Kupfer. Wie oben bereits erläutert, erhebt sich der jeweilige Abstandshalter bei dieser Ausgestaltung aus der übrigen jeweiligen elektrisch leitenden Schicht, welche außerhalb des Bereiches des jeweiligen Abstandshalters insbesondere eine plane Oberfläche aufweist.

Bei einer weiteren vorteilhaften Ausgestaltung der Erfindung weist die jeweilige elektrisch leitende Schicht dabei in der Umgebung des jeweiligen Abstandshalters zumindest eine Vertiefung auf und der jeweilige Abstandshalter ist als zumindest ein Vorsprung der jeweiligen elektrisch leitenden Schicht ausgestaltet.

Ein derart ausgestaltetes Leistungsmodul ist vergleichsweise einfach zu fertigen, da bspw. lediglich ein Arbeitsschritt bei der Bearbeitung der jeweiligen elektrisch leitenden Schicht erforderlich ist, um aus der jeweiligen elektrisch leitenden Schicht den jeweiligen Abstandshalter zu formen. Denkbar sind bspw. auch spanende Bearbeitungsverfahren, bei welchem im Bereich des jeweiligen, auszubildenden Abstandshalters ein Vorsprung aus der jeweiligen elektrisch leitenden Schicht herstellbar ist.

Bei einer weiteren vorteilhaften Ausgestaltung der Erfindung weist die zumindest eine Vertiefung je Abstandshalter dabei im Wesentlichen dasselbe Volumen wie der zumindest eine Vorsprung auf.

Beispielsweise kann der jeweilige Abstandshalter somit durch Umformen der jeweiligen elektrisch leitenden Schicht hergestellt werden, d. h. insbesondere durch Fertigungsverfahren in denen Werkstücke aus festen Rohteilen durch bleibende Formänderung erzeugt werden, sofern dabei weder Material hinzugefügt noch entfernt wird. Somit ist die Masse des Rohteils gleich der Masse des Fertigteils. Der jeweilige Abstandshalter kann bspw. durch plastische Verformung der jeweiligen elektrisch leitenden Schicht ausgebildet ist, insbesondere durch Beaufschlagung der jeweiligen elektrisch leitenden Schicht mit Druck oder durch Einbringung einer Kerbe in die jeweilige elektrisch leitende Schicht.

So kann bspw. Druck auf die jeweilige elektrisch leitende Schicht aufgebracht werden, welcher in der Umgebung des Aufbringungspunktes durch eine Materialverdrängung zu einer Erhöhung der Oberfläche der jeweiligen elektrisch leitenden Schicht führt. Der Druck kann bspw. punktuell aufgebracht werden, was einen im Wesentlichen ringförmigen jeweiligen Abstandshalter um den Aufbringungspunkt erzeugt. Alternativ kann der Druck auch durch einen ringförmigen Stempel aufgebracht werden, was einen im Wesentlichen zylinderförmigen jeweiligen Abstandshalter innerhalb des Ringes erzeugt.

Auch das Einbringen einer Kerbe in die jeweilige elektrisch leitende Schicht kann zur Erzeugung des jeweiligen Abstandshalters genutzt werden. So führt der Ansatz einer Spanbildung zur Ausbildung eines jeweiligen Abstandshalters, wobei hierbei ein abgeschälter, aber noch nicht von der übrigen jeweiligen elektrisch leitenden Schicht getrennter Span als jeweiliger Abstandshalter fungiert. Bspw. kann die Kerbe mittels eines Meißels in die jeweilige elektrisch leitende Schicht eingebracht werden.

Da bei diesen erläuterten Bearbeitungsverfahren der jeweiligen elektrisch leitenden Schicht kein Material ab- oder aufgetragen wird, weist auch die Vertiefung im Wesentlichen dasselbe Volumen wie der Vorsprung des jeweiligen Abstandshalters auf. Von Vorteil ist bei diesen Bearbeitungsverfahren, dass sie vergleichsweise einfach durchzuführen und kostengünstig sind.

Bei einer weiteren vorteilhaften Ausgestaltung der Erfindung ist der jeweilige Abstandshalter durch teilweises Abtragen der jeweiligen elektrisch leitenden Schicht ausgebildet, insbesondere mittels Ätzen oder Fräsen. Hierbei weist die jeweilige elektrisch leitende Schicht ursprünglich eine vergleichsweise große Dicke auf, welche der Summe der Zieldicke der jeweiligen elektrisch leitenden Schicht und der Höhe des jeweiligen Abstandshalters entspricht. Insbesondere wird also mit Ausnahme des jeweiligen Abstandshalters die ursprüngliche jeweilige elektrisch leitende Schicht soweit abgetragen, bis die Zieldicke der jeweiligen elektrisch leitenden Schicht erreicht ist. Lediglich der jeweilige Abstandshalter wird bei dieser Bearbeitung ausgespart und bleibt somit nach dieser Bearbeitung übrig. Der Materialabtrag kann bspw. durch Ätz- oder Fräsvorgänge erreicht werden. Insbesondere wird gemäß lediglich Material unter dem jeweiligen Leistungs-Bauelement bzw. unter der Bodenplatte abgetragen, d. h. bspw. innerhalb des oben erläuterten bspw. quader-, prismen- bzw. zylinderförmigen Raums, wobei auch hier das Material für den jeweiligen Abstandshalter ausgespart wird.

Bei einer weiteren vorteilhaften Ausgestaltung der Erfindung ist der jeweilige Abstandshalter additiv auf der jeweiligen elektrisch leitenden Schicht ausgebildet. Beispielsweise ist der jeweilige Abstandshalter zumindest teilweise mittels eines additiven Fertigungsverfahrens auf der jeweiligen elektrisch leitenden Schicht aufgebracht (bzw. hergestellt). Insbesondere wird der jeweilige Abstandshalter dabei vor dem Aufbringen des Lots der ersten bzw. zweiten Lotschicht auf der ersten bzw. zweiten elektrisch leitenden Schicht angebracht. Das bedeutet bspw., dass der jeweilige Abstandshalter nicht aus Lot besteht bzw. mehrheitlich dieses aufweist, insbesondere auch dann, wenn das während der Verarbeitung geschmolzene Lot kleine Festkörper, bspw. Kügelchen, umfasst.

Der jeweilige, additiv ausgebildete Abstandshalter kann bspw. Kupfer, Eisen oder andere Sinter-Materialien aufweisen. Sind sowohl die erste elektrisch leitende Schicht als auch der jeweilige, additiv ausgebildete erste Abstandshalter aus Kupfer gefertigt, können diese wiederum einstückig ausgebildet sein.

Bei einer weiteren vorteilhaften Ausgestaltung der Erfindung weist der jeweilige erste Abstandshalter dabei lötfähiges Material, lötfähig beschichtetes Material, Bonddraht, Kupfer, Kupferpaste und/oder Silber auf. Als lötfähig beschichtetes Material kommt bspw. Aluminium mit einer Goldbeschichtung oder Kunststoff mit einer Metallbeschichtung zum Einsatz. Für die Ausgestaltung mit Bonddraht kann vorgesehen sein, dass ein Bonddraht oder mehrere Bonddrähte auf der erste elektrisch leitenden Schicht aufgebondet oder aufgelötet wird bzw. werden, um den jeweiligen ersten Abstandshalter auszubilden. Auch die übrigen genannten Materialien können bspw. auf der ersten elektrisch leitenden Schicht aufgelötet werden, um den jeweiligen ersten Abstandshalter auszubilden.

Bei einer weiteren vorteilhaften Ausgestaltung der Erfindung ist der jeweilige Abstandshalter dabei mittels 3D-Druck, mittels eines Beschichtungsverfahrens, insbesondere Kaltgasspritzen, mittels Siebdruckes ausgebildet. Bei dem 3D-Druck wird der jeweilige Abstandshalter dabei Schicht für Schicht auf der jeweiligen elektrisch leitenden Schicht aufgetragen, wobei hierfür vorzugsweise 3D-druckbare Metalle bzw. Legierungen zum Einsatz kommen. Bei dem Kaltgasspritzen wird der Beschichtungswerkstoff, vorzugsweise ein Metall bzw. eine Legierung, in Pulverform mit sehr hoher Geschwindigkeit auf das Trägermaterial, hier die erste bzw. zweite elektrisch leitende Schicht, aufgebracht. Vorzugsweise wird hierfür eine Maske verwendet, damit lediglich Material in jenem Bereich auf die erste bzw. zweite elektrisch leitende Schicht aufgebracht wird, an welchem ein erster bzw. zweiter Abstandshalter ausgebildet werden soll. Für den Siebdruck werden dabei vorzugsweise siebdruckbare Materialien, insb. Metalle oder Legierungen verwendet. Das Aufdrucken des jeweiligen Abstandshalters auf die erste bzw. zweite elektrisch leitende Schicht, insbesondere auf die Kupferschicht eines DCB-Substrates, stellt dabei eine kostengünstige und großtechnisch umsetzbare Variante dar.

Bei einer weiteren vorteilhaften Ausgestaltung der Erfindung ist gemäß dem ersten Aspekt der zumindest eine erste Abstandshalter als zumindest zwei, vorzugsweise drei oder vier, erste Abstandshalter ausgebildet. Entsprechend kann gemäß dem zweiten Aspekt der zumindest eine zweite Abstandshalter als zumindest zwei, vorzugsweise drei oder vier, zweite Abstandshalter ausgebildet sein. Vorzugsweise ist dabei an jeder Ecke der Unter-bzw. Oberseite des jeweiligen Leistungs-Bauelementes bzw. der Bodenplatte ein jeweiliger Abstandshalter vorgesehen, bspw. also vier jeweilige Abstandshalter bei einem quaderförmigen Leistungs-Bauelement mit einer rechteckigen Grundfläche bzw. bei einer quaderförmigen Bodenplatte mit einer rechteckigen Grundflächen. Bei einigen Anwendungen können auch lediglich zwei oder drei jeweilige Abstandshalter je Leistungs-Bauelement bzw. für die Bodenplatte ausreichend sein.

Das oben erläuterte, vorgeschlagene Verfahren zur Herstellung des vorgeschlagenen Leistungsmoduls kann dabei insbesondere die im Zusammenhang mit den erläuterten vorteilhaften Ausgestaltungen Leistungsmoduls erläuterten Verfahrensschritte umfassen. Dies betrifft insbesondere die erläuterten Verfahrensschritte zur Herstellung des jeweiligen ersten Abstandshalters.

Im Folgenden wird die Erfindung anhand der in den Figuren dargestellten Ausführungsbeispiele näher beschrieben und erläutert. Es zeigen:
- FIG 1-6: ein erstes bis sechstes Ausführungsbeispiel des vorgeschlagenen Leistungsmoduls gemäß dem ersten Aspekt,
- FIG 7-12: ein siebtes bis zwölftes Ausführungsbeispiel des vorgeschlagenen Leistungsmoduls gemäß dem zweiten Aspekt,
- FIG 13: ein dreizehntes Ausführungsbeispiel des vorgeschlagenen Leistungsmoduls gemäß dem dritten Aspekt,
- FIG 14: ein Ausführungsbeispiel des vorgeschlagenen elektrischen Gerätes und
- FIG 15: ein Ablaufdiagramm eines Ausführungsbeispiels des vorgeschlagenen Verfahrens.

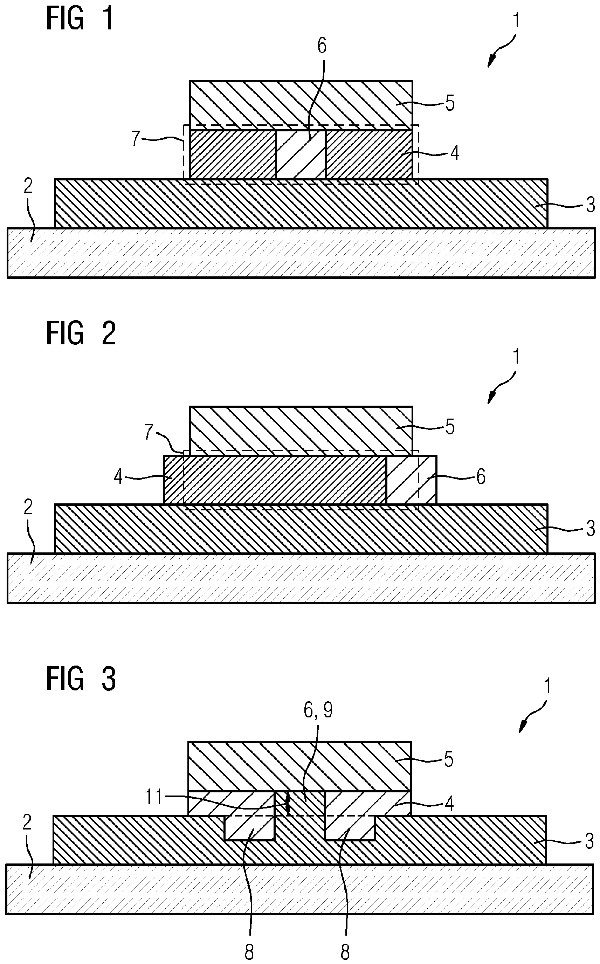

Figur 1 zeigt ein erstes Ausführungsbeispiel des vorgeschlagenen Leistungsmoduls 1 gemäß dem ersten Aspekt der Erfindung, wobei ein Querschnitt durch das Leistungsmodul 1 dargestellt ist. Das Leistungsmodul 1 weist eine elektrische isolierende Schicht 2 auf, auf welcher eine erste elektrisch leitende Schicht 3 angeordnet ist. Auf der erste elektrisch leitenden Schicht 3 sind eine erste Lotschicht 4 sowie ein erster Abstandshalter 6 angeordnet. Auf der ersten Lotschicht 4 und dem ersten Abstandshalter 6 ist ein Leistungs-Bauelement 5 angeordnet. Der erste Abstandshalter 6 ist somit zwischen dem Leistungs-Bauelement 5 und der erste elektrisch leitenden Schicht 3 angeordnet.

Wie in Figur 1 dargestellt, liegt dabei das Leistungs-Bauelement 5 auf dem ersten Abstandshalter 6 auf. Der erste Abstandshalter 6 ist im Rahmen des Ausführungsbeispiels vollständig in dem Raum 7 zwischen dem Leistungs-Bauelement 5 und der ersten elektrisch leitenden Schicht 3 angeordnet. Insbesondere kann der Raum 7 der Gestalt sein, dass er durch eine Projektion des jeweiligen Leistungs-Bauelementes 5 auf die erste elektrisch leitende Schicht 3 eingefasst ist, wobei die Projektion senkrecht auf die erste elektrisch leitende Schicht 3 erfolgt. Ein derartiger Raum 7 hätte die Form eines Quaders, Prismas bzw. Zylinders, je nach räumlicher Ausgestaltung des jeweiligen Leistungs-Bauelementes 5.

Vorzugsweise weisen der erste Abstandshalter 6 und die erste Lotschicht 4 jeweils eine Höhe bzw. Dicke von 10 µm bis 300 µm, vorzugsweise von 50 µm bis 150 µm, wobei besonders gute Eigenschaften mit einer Dicke bzw. Höhe von 90 µm bis 110 µm, d. h. etwa 100 µm, erzielbar sind.

Bei einigen Ausgestaltungen ist der erste Abstandshalter 6 additiv auf der ersten elektrisch leitenden Schicht 3 ausgebildet. Dabei kann der erste Abstandshalter 6 bspw. lötbares Material, lötfähig beschichtet des Material, Bonddraht, Kupfer, Kupferpaste und/oder Silber aufweisen. Bei einigen Alternativen ist der erste Abstandshalter 6 mittels 3D-Druck, mittels eines Beschichtungsverfahrens, insbesondere Kaltgasspritzen, oder mittels Siebdruckes ausgebildet.

Das Leistungsmodul 1 kann dabei zwei oder mehr der dargestellten ersten Abstandshalter 6 aufweisen, die bspw. auch in einer Ebene parallel zum dargestellten Querschnitt durch das Leistungsmodul 1 angeordnet sind.

Figur 2 zeigt ein zweites Ausführungsbeispiel des vorgeschlagenen Leistungsmoduls 1, wobei ein wiederum Querschnitt durch das Leistungsmodul 1 dargestellt ist. Gleiche Bezugszeichen wie in Figur 1 bezeichnen dabei gleiche Gegenstände.

Der erste Abstandshalter 6 ist gemäß dem zweiten Ausführungsbeispiel nur teilweise in dem Raum 7 zwischen dem Leistungs-Bauelement 5 und der ersten elektrisch leitenden Schicht 3 angeordnet.

Figur 3 zeigt ein drittes Ausführungsbeispiel des vorgeschlagenen Leistungsmoduls 1, wobei ein wiederum Querschnitt durch das Leistungsmodul 1 dargestellt ist.

Der erste Abstandshalter 6 und die erste elektrisch leitende Schicht 3 sind gemäß dem dritten Ausführungsbeispiel einstückig ausgebildet. Dabei weist die erste elektrisch leitende Schicht 3 in der Umgebung des ersten Abstandshalters 6 eine etwa ringförmige Vertiefung 8 auf wobei der erste Abstandshalter 6 als Vorsprung 9 der ersten elektrisch leitenden Schicht 3 ausgestaltet ist.

Der als Vorsprung 9 ausgestaltete erste Abstandshalter 6 weist dabei eine Höhe 11 gegenüber der ansonsten plan ausgestalteten erste elektrisch leitenden Schicht 3 auf. Bei einigen Varianten weist dabei die Vertiefung 8 im Wesentlichen dasselbe Volumen wie der Vorsprung 9 auf. Dies kann bspw. dadurch erreicht werden, dass auf die erste elektrisch leitenden Schicht 3 mittels eines ringförmigen Stempels Druck aufgebracht wird, wodurch eine plastische Verformung der ersten elektrisch leitenden Schicht 3 sowie eine Materialverdrängung erreicht wird, welche in einem in etwa zylinderförmigen ersten Abstandshalter 6 bzw. Vorsprung 9 resultiert.

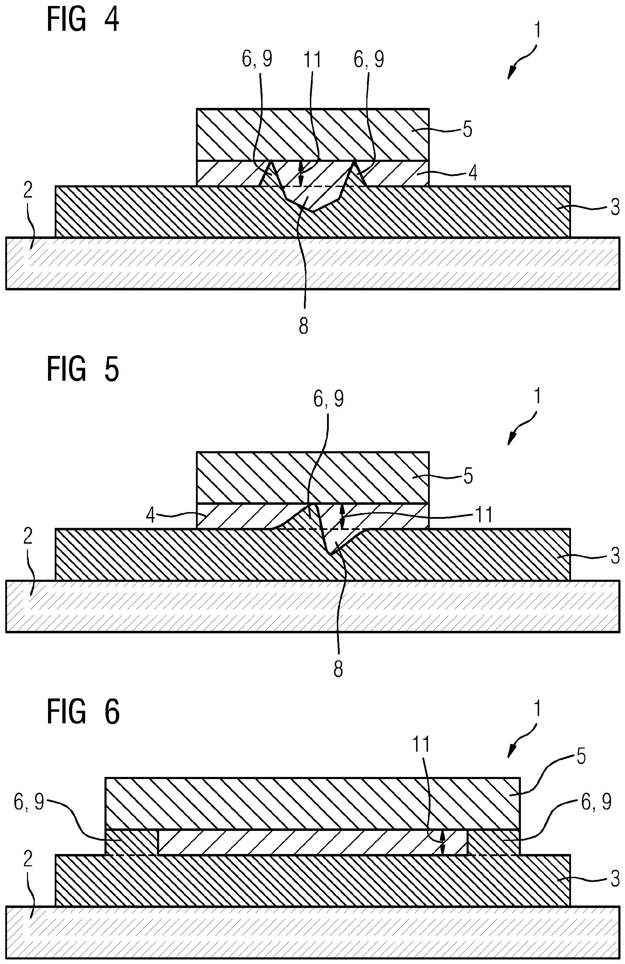

Figur 4 zeigt ein viertes Ausführungsbeispiel des vorgeschlagenen Leistungsmoduls 1, wobei ein wiederum Querschnitt durch das Leistungsmodul 1 dargestellt ist.

In Abwandlung des dritten Ausführungsbeispiels wurde auf die erste elektrisch leitende Schicht 3 mittels eines etwa zylinderförmigen Stempels Druck aufgebracht, wodurch wiederum eine plastische Verformung der ersten elektrisch leitenden Schicht 3 sowie eine Materialverdrängung erreicht wurde, welche in einem etwa ringförmigen ersten Abstandshalter 6 bzw. Vorsprung 9 resultiert.

Figur 5 zeigt ein fünftes Ausführungsbeispiel des vorgeschlagenen Leistungsmoduls 1, wobei ein wiederum Querschnitt durch das Leistungsmodul 1 dargestellt ist.

Der erste Abstandshalter 6 und die erste elektrisch leitende Schicht 3 sind gemäß dem fünften Ausführungsbeispiel einstückig ausgebildet. Der als Vorsprung 9 ausgestaltete erste Abstandshalter 6 weist dabei eine Höhe 11 gegenüber der ansonsten plan ausgestalteten erste elektrisch leitenden Schicht 3 auf. Bei einigen Varianten weist dabei die Vertiefung 8 im Wesentlichen dasselbe Volumen wie der Vorsprung 9 auf. Dies kann bspw. dadurch erreicht werden, dass auf die erste elektrisch leitende Schicht 3 mittels eines Meißels eine Kerbe in die erste elektrisch leitende Schicht 3 eingebracht wird. Dies führt zum Ansatz einer Spanbildung und damit zur Ausbildung des ersten Abstandshalters 6 bzw. Vorsprungs 9, wobei hierbei ein abgeschälter, aber noch nicht von der übrigen ersten elektrisch leitenden Schicht 3 getrennter Span als erster Abstandshalter 6 fungiert.

Figur 6 zeigt ein sechstes Ausführungsbeispiel des vorgeschlagenen Leistungsmoduls 1, wobei ein wiederum Querschnitt durch das Leistungsmodul 1 dargestellt ist.

Gemäß dem sechsten Ausführungsbeispiel weist das Leistungsmodul 1 zwei erste Abstandshalter 6 auf, welche beide mit der ersten elektrisch leitenden Schicht 3 einstückig ausgebildet sind. Die beiden ersten Abstandshalter 6 sind dabei am Rand des Leistungs-Bauelementes 5 angeordnet.

Beispielsweise sind die beiden ersten Abstandshalter 6 durch teilweises Abtragen der ersten elektrisch leitenden Schicht 3 ausgebildet, insbesondere mittels Ätzen oder Fräsen. Hierbei kann die erste elektrisch leitende Schicht 3 ursprünglich eine vergleichsweise große Dicke aufweisen, welche der Summe der Zieldicke der ersten elektrisch leitenden Schicht 3 und der Höhe 11 des jeweiligen ersten Abstandshalters 6 entspricht. Insbesondere wird also mit Ausnahme des jeweiligen ersten Abstandshalters 6 die ursprüngliche erste elektrisch leitende Schicht 3 soweit abgetragen, bis die Zieldicke der ersten elektrisch leitenden Schicht 3 erreicht ist. Lediglich der jeweilige erste Abstandshalter 6 wird bei dieser Bearbeitung ausgespart und bleibt somit nach dieser Bearbeitung übrig.

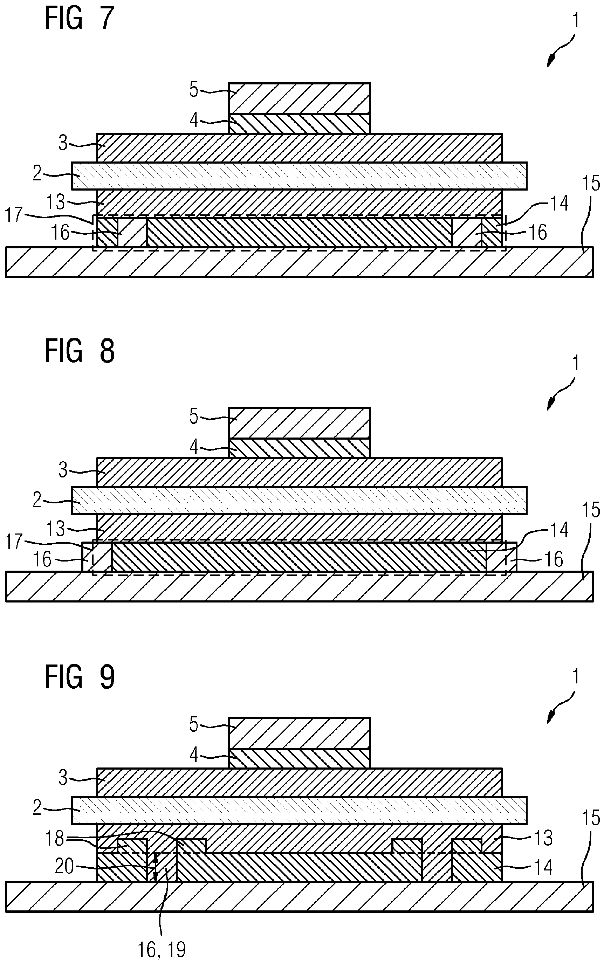

Figur 7 zeigt ein siebtes Ausführungsbeispiel des vorgeschlagenen Leistungsmoduls 1 gemäß dem zweiten Aspekt der Erfindung, wobei ein Querschnitt durch das Leistungsmodul 1 dargestellt ist. Das Leistungsmodul 1 weist eine Bodenplatte 15 auf. Weiterhin weist das Leistungsmodul 1 eine zweite Lotschicht 14 und zwei zweite Abstandshalter 16 auf, welche jeweils auf der Bodenplatte 15 angeordnet sind. Auf der zweiten Lotschicht 14 und den beiden zweiten Abstandshaltern 16 ist eine zweite elektrisch leitende Schicht 13 angeordnet. Der jeweilige zweite Abstandshalter 16 ist somit zwischen der Bodenplatte 15 und der zweiten elektrisch leitenden Schicht 13 angeordnet. Auf der zweiten elektrisch leitenden Schicht ist eine elektrisch isolierende Schicht 2 angeordnet, auf welcher wiederum eine erste elektrisch leitende Schicht 3 angeordnet ist. Auf der ersten elektrisch leitenden Schicht 3 ist eine erste Lotschicht 4 angeordnet, auf welcher ein leistungs-Bauelement 5 angeordnet ist.

Wie in Figur 7 dargestellt, liegt dabei die Bodenplatte 15 auf dem ersten Abstandshalter 6 auf. Der jeweilige zweite Abstandshalter 6 ist im Rahmen des Ausführungsbeispiels vollständig in dem Raum 17 zwischen der Bodenplatte 15 und der zweiten elektrisch leitenden Schicht 13 angeordnet. Insbesondere kann der Raum 17 der Gestalt sein, dass er durch eine Projektion der Bodenplatte 15 auf die zweite elektrisch leitende Schicht 13 eingefasst ist, wobei die Projektion senkrecht auf die zweite elektrisch leitende Schicht 13 erfolgt. Ein derartiger Raum 17 hätte die Form eines Quaders, Prismas bzw. Zylinders, je nach räumlicher Ausgestaltung der Bodenplatte 15.

Vorzugsweise weisen der jeweilige zweite Abstandshalter 16 und die zweite Lotschicht 14 jeweils eine Höhe bzw. Dicke von 10 µm bis 300 µm, vorzugsweise von 50 µm bis 150 µm, wobei besonders gute Eigenschaften mit einer Dicke bzw. Höhe von 90 µm bis 110 µm, d. h. etwa 100 µm, erzielbar sind.

Bei einigen Ausgestaltungen ist der jeweilige zweite Abstandshalter 16 additiv auf der zweiten elektrisch leitenden Schicht 13 ausgebildet. Dabei kann der jeweilige zweite Abstandshalter 16 bspw. lötbares Material, lötfähig beschichtet des Material, Bonddraht, Kupfer, Kupferpaste und/oder Silber aufweisen. Bei einigen Alternativen ist der jeweilige zweite Abstandshalter 16 mittels 3D-Druck, mittels eines Beschichtungsverfahrens, insbesondere Kaltgasspritzen, oder mittels Siebdruckes ausgebildet.

Das Leistungsmodul 1 kann dabei auch nur einen oder mehr der dargestellten zweiten Abstandshalter 16 aufweisen, die bspw. auch in einer Ebene parallel zum dargestellten Querschnitt durch das Leistungsmodul 1 angeordnet sind.

Figur 8 zeigt ein achtes Ausführungsbeispiel des vorgeschlagenen Leistungsmoduls 1, wobei ein wiederum Querschnitt durch das Leistungsmodul 1 dargestellt ist.

Der jeweilige zweite Abstandshalter 16 ist gemäß dem achten Ausführungsbeispiel nur teilweise in dem Raum 17 zwischen der Bodenplatte 15 und der zweiten elektrisch leitenden Schicht 13 angeordnet.

Figur 9 zeigt ein neuntes Ausführungsbeispiel des vorgeschlagenen Leistungsmoduls 1, wobei ein wiederum Querschnitt durch das Leistungsmodul 1 dargestellt ist.

Der jeweilige zweite Abstandshalter 16 und die zweite elektrisch leitende Schicht 13 sind gemäß dem neunten Ausführungsbeispiel einstückig ausgebildet. Dabei weist die zweite elektrisch leitende Schicht 13 in der Umgebung des jeweiligen zweiten Abstandshalters 16 eine etwa ringförmige Vertiefung 18 auf wobei der jeweilige zweite Abstandshalter 16 als Vorsprung 19 der zweiten elektrisch leitenden Schicht 13 ausgestaltet ist.

Der als Vorsprung 19 ausgestaltete zweite Abstandshalter 16 weist dabei eine Höhe 20 gegenüber der ansonsten plan ausgestalteten zweiten elektrisch leitenden Schicht 13 auf. Bei einigen Varianten weist dabei die Vertiefung 18 im Wesentlichen dasselbe Volumen wie der Vorsprung 19 auf. Dies kann bspw. dadurch erreicht werden, dass auf die zweite elektrisch leitenden Schicht 13 mittels eines ringförmigen Stempels Druck aufgebracht wird, wodurch eine plastische Verformung der zweiten elektrisch leitenden Schicht 13 sowie eine Materialverdrängung erreicht wird, welche jeweils in einem in etwa zylinderförmigen zweiten Abstandshalter 16 bzw. Vorsprung 19 resultiert.

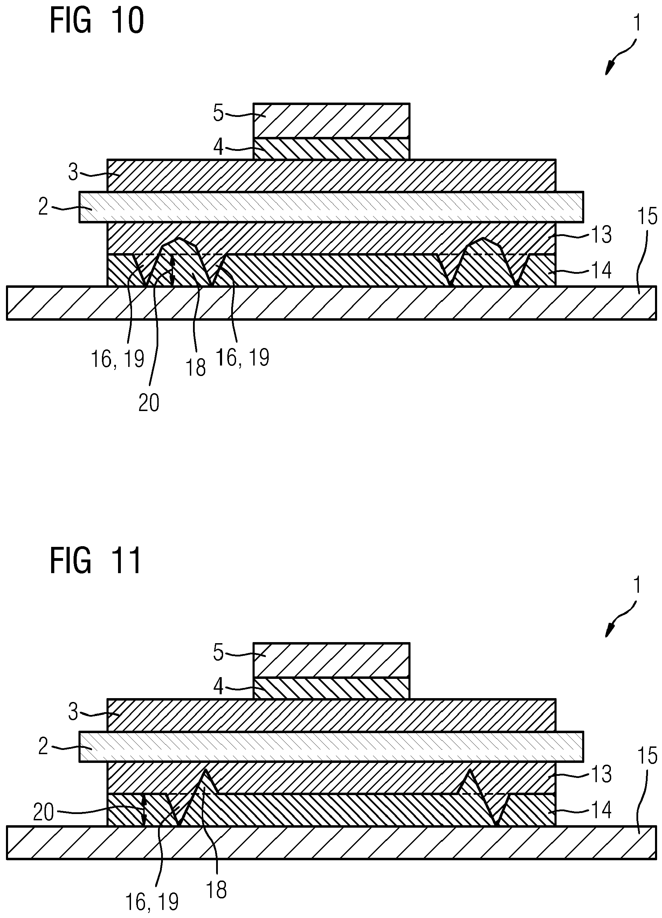

Figur 10 zeigt ein zehntes Ausführungsbeispiel des vorgeschlagenen Leistungsmoduls 1, wobei ein wiederum Querschnitt durch das Leistungsmodul 1 dargestellt ist.

In Abwandlung des neunten Ausführungsbeispiels wurde auf die zweite elektrisch leitende Schicht 13 mittels eines etwa zylinderförmigen Stempels Druck aufgebracht, wodurch wiederum eine plastische Verformung der zweiten elektrisch leitenden Schicht 13 sowie eine Materialverdrängung erreicht wurde, welche jeweils in einem etwa ringförmigen zweiten Abstandshalter 16 bzw. Vorsprung 19 resultiert.

Figur 11 zeigt ein elftes Ausführungsbeispiel des vorgeschlagenen Leistungsmoduls 1, wobei ein wiederum Querschnitt durch das Leistungsmodul 1 dargestellt ist.

Der jeweilige zweite Abstandshalter 16 und die zweite elektrisch leitende Schicht 13 sind gemäß dem elften Ausführungsbeispiel einstückig ausgebildet. Der jeweilige, als Vorsprung 19 ausgestaltete zweite Abstandshalter 16 weist dabei eine Höhe 10 gegenüber der ansonsten plan ausgestalteten zweiten elektrisch leitenden Schicht 13 auf. Bei einigen Varianten weist dabei die Vertiefung 18 im Wesentlichen dasselbe Volumen wie der Vorsprung 19 auf. Dies kann bspw. dadurch erreicht werden, dass auf die zweite elektrisch leitende Schicht 13 mittels eines Meißels eine Kerbe in die zweite elektrisch leitende Schicht 13 eingebracht wird. Dies führt zum Ansatz einer Spanbildung und damit zur Ausbildung des zweiten Abstandshalters 16 bzw. Vorsprungs 19, wobei hierbei ein abgeschälter, aber noch nicht von der übrigen zweiten elektrisch leitenden Schicht 13 getrennter Span als jeweilige zweite Abstandshalter 16 fungiert.

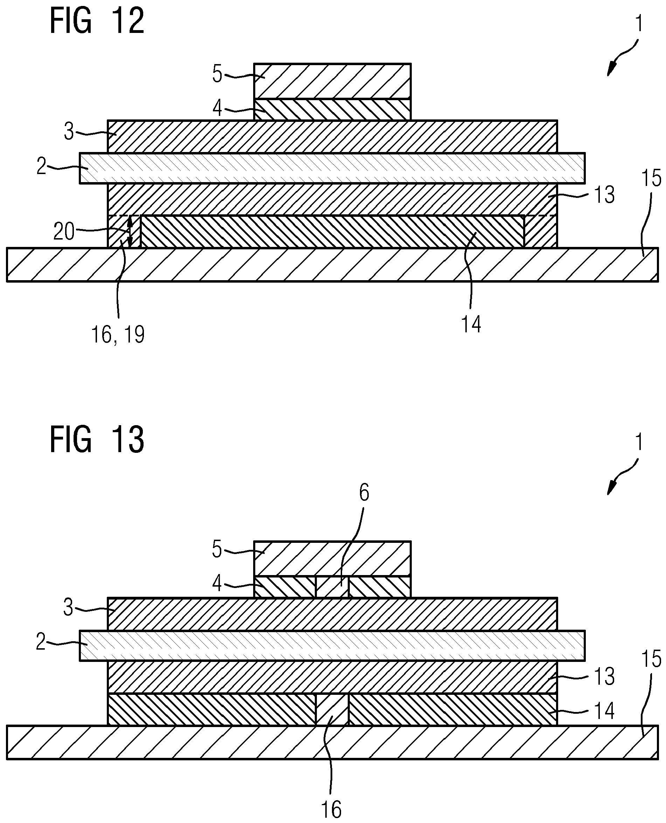

Figur 12 zeigt ein zwölftes Ausführungsbeispiel des vorgeschlagenen Leistungsmoduls 1, wobei ein wiederum Querschnitt durch das Leistungsmodul 1 dargestellt ist.

Gemäß dem zwölften Ausführungsbeispiel weist das Leistungsmodul 1 zwei zweite Abstandshalter 6 auf, welche beide mit der zweiten elektrisch leitenden Schicht 13 einstückig ausgebildet sind. Die beiden ersten Abstandshalter 16 sind dabei am Rand der Bodenplatte fünf angeordnet.

Beispielsweise sind die beiden zweiten Abstandshalter 16 durch teilweises Abtragen der zweiten elektrisch leitenden Schicht 13 ausgebildet, insbesondere mittels Ätzen oder Fräsen. Hierbei kann die zweite elektrisch leitende Schicht 13 ursprünglich eine vergleichsweise große Dicke aufweisen, welche der Summe der Zieldicke der zweiten elektrisch leitenden Schicht 13 und der Höhe 20 des jeweiligen zweiten Abstandshalters 16 entspricht. Insbesondere wird also mit Ausnahme des jeweiligen zweiten Abstandshalters 16 die ursprüngliche zweite elektrisch leitende Schicht 13 soweit abgetragen, bis die Zieldicke der zweiten elektrisch leitenden Schicht 3 erreicht ist. Lediglich der jeweilige zweite Abstandshalter 16 wird bei dieser Bearbeitung ausgespart und bleibt somit nach dieser Bearbeitung übrig.

Figur 13 zeigt ein dreizehntes Ausführungsbeispiel des vorgeschlagenen Leistungsmoduls 1 gemäß dem dritten Aspekt der Erfindung, wobei ein wiederum Querschnitt durch das Leistungsmodul 1 dargestellt ist.

Das Leistungsmodul 1 umfasst eine Bodenplatte 15, eine zweite Lotschicht 14, welche auf der Bodenplatte 15 angeordnet ist, eine zweite elektrisch leitende Schicht 13, welche auf der zweiten Lotschicht 14 angeordnet ist, eine elektrisch isolierende Schicht 2, welche auf der zweiten elektrisch leitenden Schicht 13 angeordnet ist, eine erste elektrisch leitende Schicht 3, welche auf der elektrisch isolierenden Schicht 2 angeordnet ist, eine erste Lotschicht 4, welche auf der ersten elektrisch leitenden Schicht 3 angeordnet ist und zumindest ein Leistungs-Bauelement 5, welches jeweils auf der ersten Lotschicht 4 angeordnet ist. Weiterhin weist das Leistungsmodul einen ersten Abstandshalter 6, der zwischen dem Leistungs-Bauelement 5 und der ersten elektrisch leitenden Schicht 3 angeordnet ist, und einen zweiten Abstandshalter 16 auf, der zwischen der Bodenplatte 15 und der zweiten elektrisch leitenden Schicht 13 angeordnet ist.

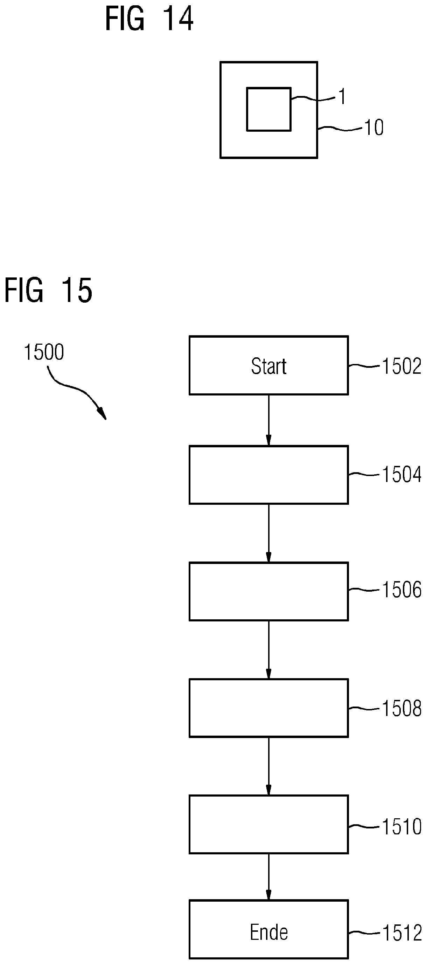

Figur 14 zeigt ein Ausführungsbeispiel des vorgeschlagenen elektrischen Gerätes 10, welches das vorgeschlagene Leistungsmodul 1 aufweist. Das Gerät kann bspw. als Gleichrichter, Wechselrichter bzw. ganz allgemein Umrichter oder Stromrichter ausgestaltet sein und insbesondere drei oder mehr der vorgeschlagene Leistungsmodul 1 aufweisen. Insbesondere kann das vorgeschlagene Leistungsmodul 1 oder ein entsprechender Umrichter bei elektrisch oder hybrid-angetriebenen Fahrzeugen, wie zum Beispiel bei Zügen, Autos oder Flugzeugen eingesetzt werden.

Figur 15 zeigt ein Ablaufdiagramm 1500 eines Ausführungsbeispiels des vorgeschlagenen Verfahrens zur Herstellung des vorgeschlagenen Leistungsmoduls gemäß dem ersten Aspekt der Erfindung. Der Ablauf startet mit Schritt 1502 und umfasst zumindest die folgenden Schritte. Bei Schritt 1504 werden eine elektrisch isolierende Schicht, eine erste elektrisch leitende Schicht, welche auf der elektrisch isolierenden Schicht angeordnet ist, sowie zumindest ein Leistungs-Bauelement bereitgestellt. Bei Schritt 1506 wird zumindest ein erster Abstandshalter ausgeformt, der jeweils zwischen einem Bereich, an welchem das jeweilige Leistungs-Bauelement anzuordnen ist, und der ersten elektrisch leitenden Schicht bzw. der elektrisch isolierenden Schicht angeordnet ist. Bei Schritt 1508 wird eine erste Lotschicht auf der ersten elektrisch leitenden Schicht zwischen der ersten elektrisch leitenden Schicht und dem Bereich, an welchem das jeweilige Leistungs-Bauelement anzuordnen ist, angebracht. Bei Schritt 1510 wird das jeweilige Leistungs-Bauelement auf der ersten Lotschicht und dem jeweiligen ersten Abstandshalter an dem Bereich angebracht, an welchem das jeweilige Leistungs-Bauelement anzuordnen ist. Der Ablauf endet mit Schritt 1512.

Alternativ kann das Ablaufdiagramm 1500 ein Ausführungsbeispiels des vorgeschlagenen Verfahrens zur Herstellung des vorgeschlagenen Leistungsmoduls gemäß dem zweiten Aspekt der Erfindung zeigen. Der Ablauf startet mit Schritt 1502 und umfasst zumindest die folgenden Schritte. Bei Schritt 1504 werden eine Bodenplatte, eine zweite elektrisch leitende Schicht, eine elektrisch isolierende Schicht, welche auf der zweiten elektrisch leitenden Schicht angeordnet ist, eine erste elektrisch leitende Schicht, welche auf der elektrisch isolierenden Schicht angeordnet ist, eine erste Lotschicht, welche auf der ersten elektrisch leitenden Schicht angeordnet ist und zumindest eines Leistungs-Bauelement bereitgestellt, welches jeweils auf der ersten Lotschicht angeordnet ist. Bei Schritt 1506 wird zumindest ein zweiter Abstandshalters ausgeformt, der jeweils zwischen der Bodenplatte und der zweiten elektrisch leitenden Schicht angeordnet ist. Bei Schritt 1506 wird eine zweite Lotschicht auf der zweiten elektrisch leitenden Schicht zwischen der zweiten elektrisch leitenden Schicht und dem Bereich angeordnet, an welchem die Bodenplatte anzuordnen ist. Bei Schritt 1510 wird die Bodenplatte auf der zweiten Lotschicht und dem jeweiligen zweiten Abstandshalter an dem Bereich angebracht, an welchem die Bodenplatte anzuordnen ist. Der Ablauf endet mit Schritt 1512.

Bei vorteilhaften Ausgestaltungen des Verfahrens kann das Ablaufdiagramm noch weitere Schritte umfassen, die weiter oben, insbesondere im Zusammenhang mit den verschiedenen ersten und zweiten Abstandshaltern und deren Erzeugung, bereits erläutert wurden. Insbesondere kann das Verfahren die zur Herstellung eines Leistungsmoduls gemäß dem dritten Aspekt der Erfindung, aufweisend sowohl zumindest einen ersten Abstandshalter als auch zumindest einen zweiten Abstandshalter, erläuterten Schritte umfassen.

## Patentansprüche

1. Leistungsmodul (1) umfassend
- eine elektrisch isolierende Schicht (2),
- eine erste elektrisch leitende Schicht (3), welche auf der elektrisch isolierenden Schicht (2) angeordnet ist,
- eine erste Lotschicht (4), welche auf der ersten elektrisch leitenden Schicht (3) angeordnet ist und
- zumindest ein Leistungs-Bauelement (5), welches jeweils auf der ersten Lotschicht (4) angeordnet ist,
**gekennzeichnet durch**
- zumindest einen ersten Abstandshalter (6), der jeweils zwischen dem jeweiligen Leistungs-Bauelement (5) und der ersten elektrisch leitenden Schicht (3) bzw. der elektrisch isolierenden Schicht (2) angeordnet ist.

2. Leistungsmodul (1) umfassend
- eine Bodenplatte (15),
- eine zweite Lotschicht (14), welche auf der Bodenplatte (15) angeordnet ist,
- eine zweite elektrisch leitende Schicht (13), welche auf der zweiten Lotschicht (14) angeordnet ist,
- eine elektrisch isolierende Schicht (2), welche auf der zweiten elektrisch leitenden Schicht (13) angeordnet ist,
- eine erste elektrisch leitende Schicht (3), welche auf der elektrisch isolierenden Schicht (2) angeordnet ist,
- eine erste Lotschicht (4), welche auf der ersten elektrisch leitenden Schicht (3) angeordnet ist und
- zumindest ein Leistungs-Bauelement (5), welches jeweils auf der ersten Lotschicht (4) angeordnet ist,
**gekennzeichnet durch**
- zumindest einen zweiten Abstandshalter (16), der jeweils zwischen der Bodenplatte (15) und der zweiten elektrisch leitenden Schicht (13) angeordnet ist.

3. Leistungsmodul (1) nach zumindest einem der vorhergehenden Ansprüche,
wobei das jeweilige Leistungs-Bauelement (5) und/oder die Bodenplatte (15) auf dem jeweiligen Abstandshalter (6, 16) aufliegt.

4. Leistungsmodul (1) nach zumindest einem der vorhergehenden Ansprüche,
wobei der jeweilige Abstandshalter (6, 16) zumindest teilweise in dem Raum (7, 17) zwischen einerseits dem jeweiligen Leistungs-Bauelement (5) bzw. der Bodenplatte (15) und andererseits der ersten elektrisch leitenden Schicht (3) bzw. der elektrisch isolierenden Schicht (2) bzw. zweiten elektrisch leitenden Schicht (13) angeordnet ist.

5. Leistungsmodul (1) nach zumindest einem der vorhergehenden Ansprüche,
wobei der jeweilige Abstandshalter (6, 16) und die jeweilige Lotschicht (4, 14) jeweils eine Höhe bzw. Dicke von 10 µm bis 300 µm, vorzugsweise von 50 µm bis 150 µm, aufweisen.

6. Leistungsmodul (1) nach zumindest einem der vorhergehenden Ansprüche,
wobei der jeweilige Abstandshalter (6, 16) und die jeweilige elektrisch leitende Schicht (3, 13) einstückig ausgebildet sind.

7. Leistungsmodul (1) nach Anspruch 6,
wobei die jeweilige elektrisch leitende Schicht (3, 13) in der Umgebung des jeweiligen Abstandshalters (6, 16) zumindest eine Vertiefung (8, 18) aufweist und
wobei der jeweilige Abstandshalter (6, 16) als zumindest ein Vorsprung (9, 19) der jeweiligen elektrisch leitenden Schicht (3, 13) ausgestaltet ist.

8. Leistungsmodul (1) nach Anspruch 7,
wobei je Abstandshalter (6, 16) die zumindest eine Vertiefung (8, 18) im Wesentlichen dasselbe Volumen wie der zumindest eine Vorsprung (9, 19) aufweist.

9. Leistungsmodul (1) nach Anspruch 6,
wobei der jeweilige Abstandshalter (6, 16) durch teilweises Abtragen der jeweiligen elektrisch leitenden Schicht (3, 13) ausgebildet ist, insbesondere mittels Ätzen oder Fräsen.

10. Leistungsmodul (1) nach zumindest einem der Ansprüche 1 bis 6,
wobei der jeweilige Abstandshalter (6, 16) additiv auf der jeweiligen elektrisch leitenden Schicht (3, 13) ausgebildet ist.

11. Leistungsmodul (1) nach Anspruch 10,
wobei der jeweilige Abstandshalter (6, 16) lötfähiges Material, lötfähig beschichtetes Material, Bonddraht, Kupfer, Kupferpaste und/oder Silber aufweist.

12. Leistungsmodul (1) nach Anspruch 10 oder 11,
wobei der jeweilige Abstandshalter (6, 16) mittels 3D-Druck, mittels eines Beschichtungsverfahrens, insbesondere Kaltgasspritzen, mittels Siebdruckes ausgebildet ist.

13. Elektrisches Gerät (10), insbesondere Umrichter, aufweisend zumindest ein Leistungsmodul (1) nach zumindest einem der vorhergehenden Ansprüche.

14. Verfahren zur Herstellung eines Leistungsmoduls (1) nach Anspruche 1 oder einem von Anspruch 1 abhängigen Anspruch umfassend die Verfahrensschritte:
- Bereitstellen einer elektrisch isolierenden Schicht (2), einer ersten elektrisch leitenden Schicht (3), welche auf der elektrisch isolierenden Schicht (2) angeordnet ist, sowie zumindest eines Leistungs-Bauelementes (5),
- Ausformen zumindest eines ersten Abstandshalters (6), der jeweils zwischen einem Bereich, an welchem das jeweilige Leistungs-Bauelement (5) anzuordnen ist, und der ersten elektrisch leitenden Schicht (3) bzw. der elektrisch isolierenden Schicht (2) angeordnet ist,
- Anbringen einer ersten Lotschicht (4) auf der ersten elektrisch leitenden Schicht (3) zwischen der ersten elektrisch leitenden Schicht (3) und dem Bereich, an welchem das jeweilige Leistungs-Bauelement (5) anzuordnen ist,
- Anbringen des jeweiligen Leistungs-Bauelementes (5) auf der ersten Lotschicht (4) und dem jeweiligen ersten Abstandshalter (6) an dem Bereich, an welchem das jeweilige Leistungs-Bauelement (5) anzuordnen ist.

15. Verfahren zur Herstellung eines Leistungsmoduls (1) nach Anspruch 2 oder einem von Anspruch 2 abhängigen Anspruch umfassend die Verfahrensschritte:
- Bereitstellen einer Bodenplatte (15), einer zweiten elektrisch leitende Schicht (13), einer elektrisch isolierende Schicht (2), welche auf der zweiten elektrisch leitenden Schicht (13) angeordnet ist, einer erste elektrisch leitende Schicht (3), welche auf der elektrisch isolierenden Schicht (2) angeordnet ist, einer ersten Lotschicht (4), welche auf der ersten elektrisch leitenden Schicht (3) angeordnet ist und zumindest eines Leistungs-Bauelement (5), welches jeweils auf der ersten Lotschicht (4) angeordnet ist,
- Ausformen zumindest eines zweiten Abstandshalters (16), der jeweils zwischen der Bodenplatte (15) und der zweiten elektrisch leitenden Schicht (13) angeordnet ist,
- Anbringen einer zweiten Lotschicht (14) auf der zweiten elektrisch leitenden Schicht (13) zwischen der zweiten elektrisch leitenden Schicht (13) und dem Bereich, an welchem die Bodenplatte (15) anzuordnen ist,
- Anbringen der Bodenplatte (15) auf der zweiten Lotschicht (14) und dem jeweiligen zweiten Abstandshalter (16) an dem Bereich, an welchem die Bodenplatte (15) anzuordnen ist.
